# EUROPEAN PATENT APPLICATION

(11) **EP 4 661 294 A1**
(43) Date of publication of application: **10.12.2025**
(21) Application number: 25177691.0
(22) Date of filing: 20.05.2025
(51) Int. Cl.: H03L 7/081

(54) **DELAY LOCKED LOOP (DLL) CIRCUIT WITH DUTY CYCLE CORRECTION**

(30) Priority: 05.06.2024 IN 202441043544
(71) Applicant: NXP USA, Inc., Austin, TX 78735 (US)
(72) Inventor: Bugade, Vishwajit Babasaheb, 5656AG Eindhoven (NL); Sinha, Anand Kumar, 5656AG Eindhoven (NL)
(74) Representative: Miles, John Richard

(57) **Abstract**

A delay locked loop (DLL) circuit includes a delay line which receives an input clock, and provides an output clock which is phase shifted 360 degrees and an intermediate clock which is phase shifted less than 360 degrees from the input clock. A DLL loop receives the input clock as a DLL reference clock and the output clock as a DLL feedback clock, and outputs a first control voltage to adjust first edges of the input clock. A duty cycle correction (DCC) loop receives the intermediate clock as a DCC reference clock and an inverse of the output clock as a DCC feedback clock, and outputs a second control voltage to adjust second edges of the input clock, independent of the first edges of the input clock. The DCC loop is enabled after the DLL loop achieves lock between the first edges of the output clock and the input clock.

## Description

### BACKGROUND

### Field

This disclosure relates generally to integrated circuits, and more specifically, to a delay locked loop circuit with duty cycle correction.

### Related Art

A delay locked loop (DLL) is widely used as a timing circuit in many systems for various purposes such as clock generation, signal synchronization, etc. Conventional DLL circuits deals with the rising edge of the clock and delaying the clock signal without correcting its duty cycle. However, in many application, in which high speed circuits and logic families are implemented, double data rate is used in which both the rising and falling edges trigger data operation. Therefore, with the constant desire for higher data rates, the distortions in clock duty cycle limit the maximum possible frequency and hence speed of operation. Therefore, a need exists for a DLL circuit which achieves duty cycle correction which may be used for improved clock generation.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, a delay locked loop (DLL) circuit having a duty cycle correction (DCC) circuit, in accordance with an embodiment of the present invention.
FIG. 2 illustrates a timing diagram of various waveforms in the DLL circuit of FIG. 1, in accordance with an embodiment of the present invention.
FIG. 3 illustrates, in partial block diagram and partial schematic form, a more detailed view of the DLL circuit with the DCC circuit of FIG. 1, in accordance with an embodiment of the present invention.
FIG. 4 illustrates the DLL circuit of FIG. 3 with an additional delay line, in accordance with an embodiment of the present invention.
FIG. 5 illustrates, in partial schematic and partial block diagram form, a delay line useable in FIGs. 3 and 4, in accordance with an embodiment of the present invention.
FIG. 6 illustrates a control circuit for a charge pump of the DLL circuit of FIG. 3, in accordance with an embodiment of the present invention.
FIG. 7 illustrates, in partial schematic and partial block diagram form, more detailed views of a charge pump and a DCC circuit charge pump of the DLL circuit useable in FIG. 3, in accordance with an embodiment of the present invention.
FIG. 8 illustrates, in partial schematic and partial block diagram form, a DCC circuit charge pump useable in FIG. 3, in accordance with an embodiment of the present invention.
FIGs. 9-11 illustrate various waveforms of the DLL circuit of FIG. 3, in accordance with embodiments of the present invention.

### DETAILED DESCRIPTION

A duty cycle correction (DCC) circuit is used within a DLL circuit in order to ensure an accurate duty cycle. While conventional DLL circuits typically control the rising edge of the clock for locking, the DCC circuit, in accordance with an embodiment of the present invention, controls the falling edge to correct the duty cycle in order to obtain and accurate 50% duty cycle. In this manner, the DLL circuit includes a first loop for delay locking of the rising edge of the clock, and the DCC adds a second loop which, upon the first loop achieving delay lock, controls the falling edge to achieve the desired duty cycle. In one embodiment, both the first and second loop are implemented using a same (i.e. shared) delay line to control the rising and falling edges by providing independent controls to the same delay line. By incorporating the DCC into the DLL circuit with a single delay line, reduced circuit size and complexity may be achieved.

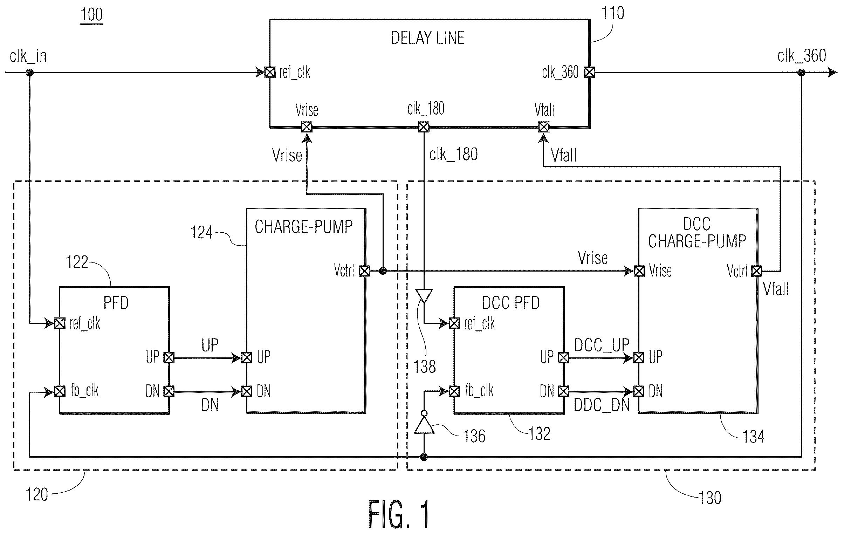

FIG. 1 illustrates, in block diagram form, a DLL circuit 100 (referred to herein as DLL 100) receives an input clock (clk_in) and generates an output clock (clk_360), and includes a first loop 120 (referred to as DLL loop 120 or loop 120), a second loop 130 (referred to as a DCC loop 130 or loop 130), and a shared delay line 110 (also referred to as a same delay line or single delay line or simply delay line 110), in accordance with one embodiment of the present invention. In one embodiment, delay line 110 and loop 120 perform the primary function of DLL circuit 100 to perform delay locking by controlling the rising edges in delay line 110, while delay line 110 and loop 130 may be referred to as the DCC circuit which performs duty cycle correction by controlling the falling edges in delay line 110. Therefore, as illustrated in FIG. 1, delay line receives a first control voltage (Vrise) from loop 120 to control rising edge delays and a second control voltage (Vfall) from loop 130 to control falling edge delays.

Each loop includes a corresponding phase frequency detector (PFD) and charge pump (CP). Loop 120 includes DLL PFD 122 and DLL CP 124, and loop 130 includes DCC PFD 132 and DCC CP 134. Each PFD receives a reference clock (ref_clk) and a feedback clock (fb_clk), and each provides up/down control signals to the corresponding CP. For example, PFD 122 receives clk_in as its ref_clk and clk_360 as its fb_clk, and provides control signals up (UP) and down (DN) (and although not illustrated in FIG. 1, also provides the inverse of these signals UP_b and DN_b, in which these up/down signals within DLL loop 120 may collectively be referred to as a set of DLL control signals) to CP 124. CP 124 provides its output control voltage (Vctrl) as Vrise to delay line 110 and to DCC CP 134. Delay line 110 receives clk_in as its ref_clk and provides clk_360 as an output clock, in which the rising edges of clk_360 are phase shifted by 360 degrees (e.g. one clock cycle) from clk_in. PFD 122, CP 124, and delay line 110 operate as a conventional DLL circuit, in which clk_360 is delay locked to clk_in, meaning that at steady state, the rising edges of clk_360 are locked to the rising edges of clk_in.

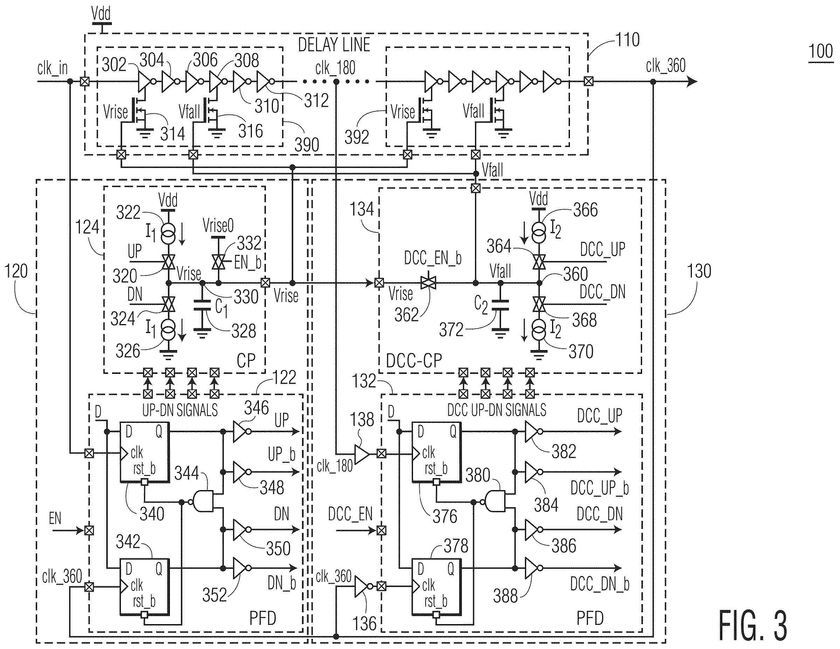

Delay line 110, in addition to providing clk_360, also provides an intermediate clock, clk_180, as an output, whose rising edge is 180 degrees shifted from clk_in. DCC PFD 132 is analogous to PFD 122, but receives clk_180 (via a buffer 138) as its ref_clk and receives an inverted version of clk_360 (via an inverter 136) as its fb_clk. DCC PFD 132 provides control signals up (DCC_UP) and down (DCC_DN) (and although not illustrated in FIG. 1, the inverse of these signals DCC_UP_b and DCC_DN_b, in which these up/down signals within DCC loop 130 may collectively be referred to as a set of DCC control signals) to DCC CP 134. As will be seen in reference to FIG. 3, DCC CP 134 is slightly modified from CP 124, and provides its output control voltage (Vctrl) as Vfall to delay line 110. As will be described in more detail below, the control voltage Vrise operates to shift the rising edges of clk_in while not affecting or shifting the falling edges, while Vfall operates independently to shift the falling edges of clk_in while not affecting or shifting the rising edges. In this manner, loop 120 is capable of affecting the rising edges while loop 130 is capable of affecting the falling edges, independent of the rising edges. Note that each of PFD 122 and DCC PFD 132 operate as known in the art to produce the corresponding up/down control signals, and each of CP 124 and DCC CP 134 operate as known in the art in response to the up/down control signals to affect (e.g. charge/discharge) the corresponding output control voltages (Vrise and Vfall).

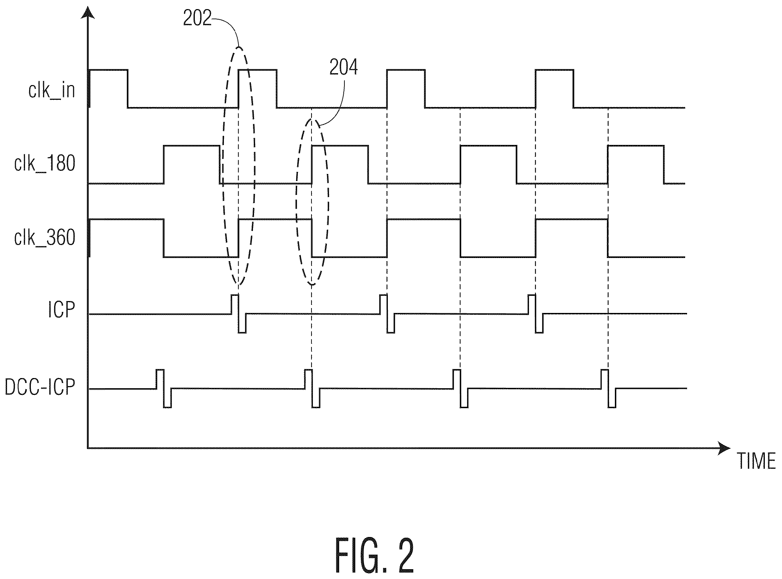

FIG. 2 illustrates waveforms corresponding to clk_in, clk_180, and clk_360 of FIG. 1, in accordance to one embodiment of the present invention. Also illustrated in FIG. 2 are current to CP (ICP) and current to DCC CP (DCC-ICP) control signals, in which each is illustrated with a positive pulse and negative pulse to represent values of the corresponding up and down control signals which control current to or from the capacitor of the corresponding CP, as will be described in more detail below. (Therefore, these current signals are included to just represent timing of error correction operation of each loop. That is, ICP represents timing of the error correction operation of the DLL loop, and DCC_ICP represents timing of the error correction operation of the DCC loop.) The waveforms of FIG. 2 represent steady state operation of DLL 100, once both loops 120 and 130 are locked. In the illustrated embodiment, clk_in is received having a clock cycle of T (the time between two successive rising edges) and a duty cycle of less than 50%. Clk_360 is the output clock whose rising edges are locked to the rising edges of clk_in, as illustrated by the example within dotted circle 202, whose clock cycle is also T but whose duty cycle has been extended to 50%. Clk_180 is a 180 degree shifted intermediate clock whose rising edges occur half way between rising edges of clk_in, thus its rising edges are locked to the falling edges of clk_360, as illustrated by the example within dotted circle 204. That is, the rising edges of clk_180 and the falling edges of clk_360 occur at T/2 with respect to clk_in.

In operation, to achieve the steady state of FIG. 2, loop 120 achieves lock first such that clk_360 is phase locked to clk_in (in that rising edges of clk_360 are locked with rising edges of clk_in), followed by loop 130 adjusting the duty cycle of clk_360 such that it achieves a corrected 50% duty cycle. Note that in the case that the duty cycle of clk_in is initially less than 50%, as in FIG. 2, loop 130 increases the duty cycle incrementally to achieve the corrected 50% duty cycle, but if greater than 50%, then loop 130 decreases the duty cycle incrementally to achieve the corrected 50% duty cycle. In the illustrated embodiment of FIG. 2, the duty cycle of clk_180 is therefore between the duty cycle of clk_in and clk_360.

FIG. 3 illustrates a more detailed view of DLL circuit 100 of FIG. 1, in accordance with an embodiment of the present invention. Delay line 110 includes a first delay unit 390 including a first set of series-connected inverters (e.g. inverters 302-312 powered between a first power supply terminal and a second power supply terminal) which receives clk_in and outputs clk_180, and a second delay unit 392 including a second set of series-connected inverters (powered between the first power supply terminal and the second power supply terminal) which receives clk_180 and outputs clk_360 at the output of delay line 110. The first power supply terminal supplies a first supply voltage, Vdd, and the second power supply terminal supplies a second supply voltage, ground, in which Vdd is greater than ground. (Note that for the descriptions herein, each of the voltage supply terminals can be referred to simply as Vdd or ground.) Delay line 110 is implemented as a shared delay line, in which each of the clock outputs of delay line 110, including clk_180 and clk_360, correspond to different taps of the shared delay line. A first inverter 302 of the series-connected inverters of delay unit 390 is coupled via an n-channel metal-oxide-semiconductor (NMOS) transistor 314 to ground, in which a first current electrode of transistor 314 is coupled to a low power node of inverter 302, a second current electrode is coupled to ground, and a control electrode is coupled to receive Vrise. A second inverter 308 of the series-connected inverters of delay unit 390 is coupled via an NMOS transistor 316 to ground, in which a first current electrode is coupled to a low power node of inverter 308, a second current electrode is coupled to ground, and a control electrode is coupled to receive Vfall.

Note that delay unit 392 is analogous to delay unit 390, including a same number of series-connected inverters, including an additional NMOS transistor coupled to a first inverter controlled by Vrise and an additional NMOS transistor coupled a second inverter controlled by Vfall. As will be described below, Vrise affects rising edges of the clock signal through delay line 110 while Vfall affects falling edges of the clock signal through delay line 110. Note also that each inverter of the series-connected inverters may be referred to as an inverter stage, in which an inverter stage may or may not include an additional pull-down NMOS transistor coupled between the inverter and ground (such as transistors 314 and 316). An inverter stage with a corresponding additional pull-down NMOS transistor may collectively be referred to as a control stage.

Referring next to PFD 122, PFD 122 includes D flip flops (DFFs) 340 and 342, buffers 346 and 350, inverters 348 and 352, and a NAND gate 344. The D inputs of DFFs 340 and 342 receive input "D" of PFD 122, the clock input of DFF 340 receives the ref_clk (clk_in), the clock input of DFF 342 receives the fb_clk (clk_360), inverse RESET inputs (rst_b) of DFFs 340 and 342 are coupled to an output of NAND gate 344. A Q output of DFF 340 is coupled to an input of buffer 346, an input of inverter 348, and a first input of NAND gate 344. A Q output of DFF 342 is coupled to an input of buffer 350, an input of inverter 352, and a second input of NAND gate 344. An output of buffer 346 provides the control signal UP, an output of inverter 348 provides the control signal UP_b, an output of buffer 350 provides the control signal DN, and an output of inverter 352 provides the control signal DN_b. Each of the DFFs operates by providing its input D at its output Q upon the rising edge of its input clock. When rst_b is asserted (to a logic level zero), the output Q is reset to a logic level zero.

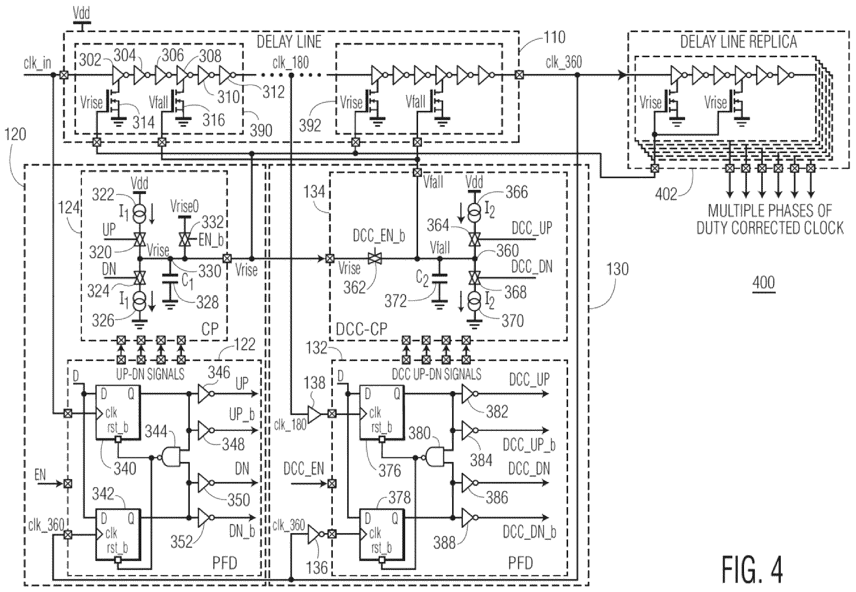

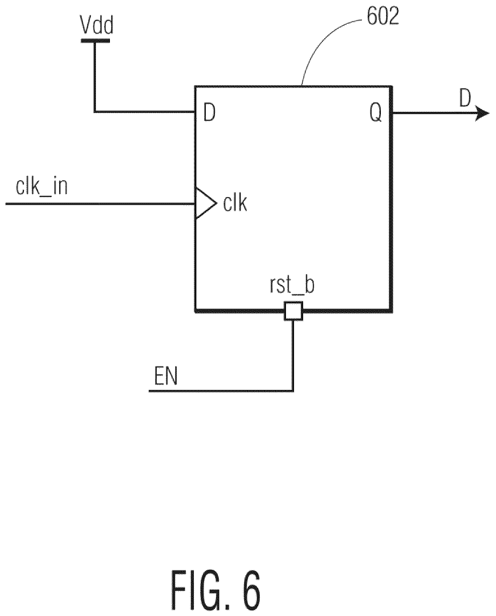

For the illustrated embodiment of FIG. 3, the value of D is generated by a control circuit of PFD 122 based on an input enable signal EN, as illustrated in FIG. 6. The EN signal corresponds to the enable signal of DLL 100 in which, when asserted to a logic level one, allows DLL 100 to begin operation by allowing loop 120 to begin its locking operation. FIG. 4 illustrates a DFF 602 having its D input coupled to Vdd (corresponding to a logic level one), its clock input coupled to receive clk_in, its inverse RESET input (rst_b) coupled to receive EN, and its Q output provides "D" to the D inputs of DFFs 340 and 342. Note that DFF 602 operates to mask the first rising edge of the ref_clk to affect "D" to allow for proper startup of the DLL. Once EN is asserted to a logic level one, "D" is continuously provided as a logic level one, and when EN is negated to disable DLL 100, "D" is negated to a logic level zero which then forces UP and DN to zero (thus no longer affecting CP 124).

In operation, referring to PFD 122, when the rising edge of the reference clock (clk_in) leads (i.e. occurs before) the rising edge of the feedback clock (clk_360), the Q output of DFF 340 is asserted to a logic level one in response to the rising edge of clk_in, resulting in asserting UP to a logic level one, while the Q output of DFF 342 remains a logic level zero, which maintains DN negated at a logic level zero. With the inputs of NAND gate 344 being different, the output of NAND gate 344 remains asserted at a logic level one. Later in time, in response to the next rising edge of clk_360, the Q output of DFF 342 is asserted to a logic level one, causing DN to be asserted to a logic level one as well. This results in the output of NAND gate 344 falling to zero which resets the Q outputs of DFF flip flops 340 and 342 back to zero. In this case, the UP pulse will be longer than the DN pulse, in which the DN pulse will be at a minimum pulse width provided by PFD 122. Also, the greater the amount that the reference clock leads the feedback clock, the longer the UP pulse.

On the other hand, when the rising edge of the reference clock (clk_in) lags (i.e. occurs after) the rising edge of the feedback clock (clk_360), the Q output of DFF 342 is asserted to a logic level one in response to the rising edge of clk_360, resulting in asserting DN to a logic level one, while the Q output of DFF 340 remains a logic level zero, which maintains UP negated at a logic level zero. Later in time, in response to the next rising edge of clk_in, the Q output of DFF 340 is asserted to a logic level one, causing UP to be asserted to a logic level one as well. This results in the output of NAND gate 344 falling to zero which resets the Q outputs of DFF flip flops 340 and 342 back to zero. In this case, the DN pulse will be longer than the UP pulse, in which the UP pulse will be at a minimum pulse width provided by PFD 122. Also, the greater the amount that the reference clock lags the feedback clock, the longer the DN pulse.

In the case that the rising edges are aligned, the Q outputs of DFFs 340 and 342 will both be asserted at the same time, and then be negated in response to the output of NAND gate 344 being negated at the rst_b inputs. The pulse widths of the UP and DN pulses in this case will both be at the minimum pulse width provided by PFD 122. Note that UP_b and DN_b are provided as inverses of UP and DN, respectively. The up/down signals are provided to CP 124 to control Vrise, in which assertion of the UP signal to a logic level one (with DN negated to a logic level zero) results in charging Vrise, and assertion of the DN signal to a logic level one (with UP negated to a logic level zero) results in discharging Vrise, as will be described below in reference to CP 124 of FIG. 3. The amount of charging or discharging Vrise is proportional to the pulse width of the UP pulse and DN pulse, respectively, in which the greater the pulse width, the greater the increase or decrease of Vrise, respectively. Therefore, as illustrated in FIG. 2, which represents the steady state of DLL circuit 100, ICP represents the up/down pulses provided to CP 124 in response to the comparison between each rising edge of clk_in with a corresponding rising edge of clk_360 (one cycle later, when it is fedback as the fb_clk to PFD 122).

DCC PFD 132 of FIG. 3 (also referred to simply as PFD 132) includes DFFs 376 and 378, buffers 382 and 386, inverters 384 and 388, and a NAND gate 380. The D inputs of DFFs 376 and 378 receive input "D" of PFD 132, the clock input of DFF 376 receives the ref_clk (clk _180), the clock input of DFF 378 receives the fb_clk (the inverse of clk_360, via inverter 136), rst_b inputs of DFFs 376 and 378 are coupled to an output of NAND gate 380. A Q output of DFF 376 is coupled to an input of buffer 382, an input of inverter 384, and a first input of NAND gate 380. A Q output of DFF 378 is coupled to an input of buffer 386, an input of inverter 388, and a second input of NAND gate 380. An output of buffer 382 provides the control signal DCC_UP, an output of inverter 384 provides the control signal DCC_UP_b, an output of buffer 386 provides the control signal DCC_DN, and an output of inverter 388 provides the control signal DCC_DN_b.

PFD 132 operates analogously to PFD 122 to provide DCC_UP and DCC_DN signals to CP 134. That is, elements 340, 342, 344, 346, 348, 350, and 352 of PFD 122 operate analogously to elements 376, 378, 380, 382, 384, 386, and 388 of PFD 132, respectively, in which the descriptions for these elements above in reference to PFD 122 also apply to PFD 132. For example, when clk_180 leads the inverse of clk_360, DCC_UP is asserted prior to asserting DCC_DN, and vice versa when clk_180 lags the inverse of clk_180. In this case, though, since the inverse of clk_360 is provided as the fb_clk to PFD 132, rather than the up/down signals being generated based on a comparison between a rising edge of the ref_clk and a corresponding rising edge of clk_360, the up/down signals are generated based on a comparison between a rising edge of the ref_clk and a corresponding falling edge of clk_360. Therefore, as illustrated in FIG. 2, which represents the steady state of DLL circuit 100, DCC-ICP represents the up/down pulses provided to DCC-CP 134 in response to the comparison between each rising edge of clk_180 (provided as the ref_clk) with a corresponding falling edge of clk_360 (one cycle later, when the inverse is fedback as the fb_clk to PFD 132). When both the rising edges of clk_180 and the falling edges of clk_360 are aligned, the pulse widths of the DCC_UP and DCC_DN pulses will both be at the minimum pulse width provided by PFD 132.

While PFD 122 receives EN which generates "D" to DFFs 340 and 342 based on the control circuit of FIG. 6, PFD 132 receives a DCC enable signal, DCC_EN, and generates "D" to DFFs 376 and 378 based on DCC_EN. In one embodiment, "D" is provided directly as DCC_EN. Therefore, the DCC_UP/DCC_DN signals are only asserted when DCC_EN is asserted to a logic level one, which indicates DCC loop 130 is enabled. When DCC_EN is disabled (and thus negated to a logic level zero), DCC_UP and DCC_DN remain at zero as well. Note that DCC_UP_b and DCC_DN_b are provided as inverses of DCC_UP and DCC_DN, respectively. The DCC up/down signals are provided to CP 134 to control Vfall (analogous to how the up/down signals are provided to CP 124 to control Vrise), in which assertion of the DCC_UP signal to a logic level one (with DCC_DN negated to a logic level zero) results in charging Vfall, and assertion of the DCC_DN signal to a logic level one (with DCC_UP negated to a logic level zero) results in discharging Vfall, as will be described below in reference to CP 134 of FIG. 3.

Note that, in alternate embodiments, PFD 122 and PFD 132 can be implemented using any known PFD circuitry which receives a ref_clk and a fb_clk and generates up/down signals for a corresponding charge pump. Also, the "D" inputs of the DFFs can be generated differently, based on different enable signals or combination of enable signals. Also, different logic circuitry can be used to implement the functionality described above in reference to each PFD.

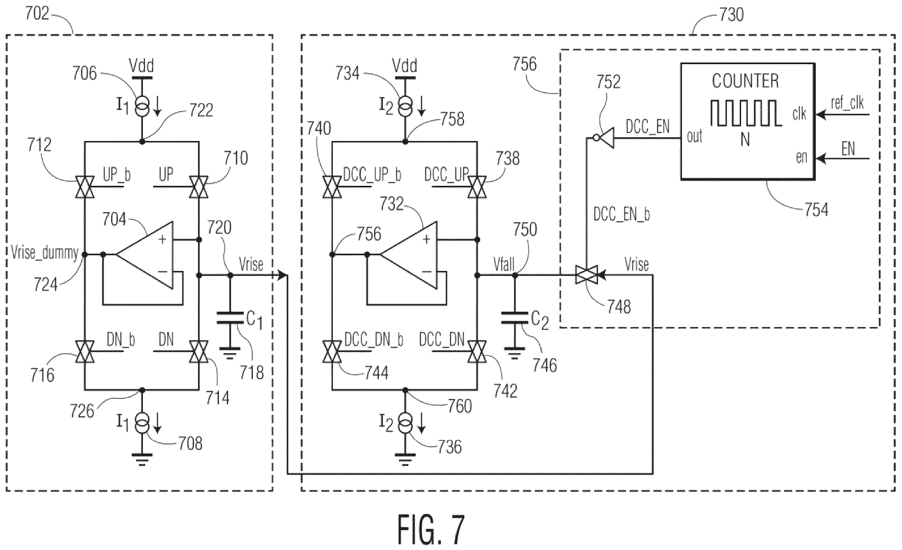

CP 124, which receives the up/down signals from PFD 122, can be implemented using any known charge pump circuitry. The version of CP 124 of FIG. 3 illustrates the functionality of CP 124, in which the functionality can be implemented with different circuitry than illustrated. (A specific embodiment of circuitry to implement CP 124 will be described in reference to FIG. 7 below.) CP 124 includes current sources 322 and 326, switches 320, 324, and 332, and a capacitor C1 328. A first terminal of current source 322 is coupled to Vdd, and a second terminal of current source 322 is coupled to a first current terminal of switch 320. A second current terminal of switch 320 is coupled to a circuit node 330 which corresponds to the control voltage (Vrise) provided by CP 124. A first current terminal of switch 324 is coupled to node 330, and a second current terminal of switch 324 is coupled to a first terminal of current source 326. A second current terminal of current source 326 is coupled to ground. Capacitor C1 is coupled between node 330 and ground. A control terminal of switch 320 is coupled to receive UP from PFD 122, and a control terminal of switch 324 is coupled to receive DN from PFD 122. A first current terminal of switch 332 is coupled to receive an input initialization voltage, Vrise0, a second current terminal of switch 332 is coupled to node 330, and a control terminal of switch 332 is coupled to receive EN_b (i.e. the inverse of EN).

For each switch illustrated herein, when the signal at the control terminal is a logic level one, the switch is "on" or "closed" and thus connects its first current terminal to its second current terminal to communicate current between the first and second current terminals (thus effectively acting as a short circuit). However, when the signal at the control terminal is a logic level zero, the switch is "off" or "open" in which the first current terminal is disconnected from the second current terminal such that the switch does not communicate current between the first and second current terminals (thus effectively acting as an open circuit).

In operation, when PFD 122 is enabled, EN is asserted at a logic level one, meaning that EN_b is negated at a logic level zero, which disconnects Vrise from node 330. With PFD 122 enabled, when UP is asserted to a logic level one by PFD 122, switch 320 is closed such that current source 322 (which provides current I1) charges C1 (thus charging or increasing Vrise). When DN is asserted to a logic level one by PFD 122, switch 324 is closed such that current source 326 discharges C1 (thus discharging or decreasing Vrise). Note that the amount of charging or discharging C1 is directly proportional to the pulse width of the corresponding UP or DN signal, respectively. When PFD 122 is disabled, EN_b is asserted at a logic level one which forces Vrise to Vrise0 (which corresponds to an initialization value).

Similar to CP 124 of FIG. 3, the version of DCC_CP 134 of FIG. 3 illustrates the functionality of DCC_CP 134, in which the functionality can be implemented with different circuitry than illustrated. (A specific embodiment of circuitry to implement DCC_CP 134 will be described in reference to FIG. 7 below.) DCC_CP 134, which receives up/down signals from PFD 132, can be implemented using any known charge pump circuitry. DCC_CP 134 includes current sources 366 and 370, switches 364, 368, and 362, and a capacitor C2 372. Note that current sources 366 and 370, switches 364 and 368, and C2 372 are coupled and operate analogously to current sources 322 and 326, switches 320 and 324, and C1 328 of CP 124, respectively. Therefore, the descriptions for these elements above in reference to CP 124 also apply to DCC_CP 134. In CP 134, circuit node 360 is located between switches 364 and 368 is analogous to node 330 of CP 124 but corresponds to the control voltage (Vfall) provided by DCC_CP 134. Also, switches 364 and 368 receive the corresponding up and down signals, respectively, from PFD 132 rather than PFD 122. Therefore, a control terminal of switch 364 receives DCC_UP from PFD 132, and a control terminal of switch 368 receives DCC_DN from PFD 132. DCC_CP 134 includes switch 362 which has a first current terminal coupled to receive Vrise from CP 124, a second current terminal coupled to node 360, and a control terminal coupled to receive DCC_EN_b (i.e. the inverse of DCC_EN).

In operation, since loop 130 is enabled after loop 120 achieves lock, prior to loop 120 achieving lock, loop 130 is disabled, in which DCC_EN is initially negated at a logic level zero (and thus DCC_EN_b is a logic level one). While DCC_EN_b is a logic level one, switch 362 is on which connects Vrise to Vfall such that Vfall=Vrise. However, once loop 130 is enabled and thus DCC_EN is asserted to a logic level one (and thus DCC_EN_b is negated to logic level zero), switch 362 disconnects Vfall from Vrise such that Vfall is controlled by DCC_UP and DCC_DN. For example, once DCC_EN is asserted, DCC_UP and DCC_DN control the charging and discharging, respectively, of C2 372 (and thus the charging and discharging of Vfall).

Referring back to the series-connected inverters of delay line 110, each inverter can be implemented as known in the art in which each in inverter includes a p-channel metal-oxide-semiconductor (PMOS) transistor coupled in series with an NMOS transistor, in which control electrodes of the series-connected PMOS and NMOS transistors corresponds to an input of the inverter, and the circuit node between he PMOS and NMOS transistors corresponds to an output of the inverter. In operation, using inverter 302 as an example, the addition of transistor 324 between inverter 302 and ground (i.e. between the NMOS transistor of the series-connected transistors of inverter 302 and ground) restricts current through the series-connected pair of transistors of inverter 302. The addition of the transistor on the pull-down path slows down the falling edge of the inverter output, and as the voltage decreases on the control electrode, the slower the falling edge. Therefore, for a rising edge on clk_in, which results in a rising edge at the input of inverter 302, the resulting falling edge on the output of inverter 302 is slowed down. This slow down of the falling edge results in next inverter 304 delaying the trigger of its rising edge. Note that since inverters 304 and 306 do not include the additional transistors in the pull-down path, the edges are sharp and are used to subsequently sharpen the slower falling edge at the output of inverter 302, but do not further affect the falling edges. Also, note that since there is also no additional transistor in the pull up path between the inverter output and Vdd, the rising edges remain sharp, with no added delay.

The addition of transistor 314 allows for a delay in the corresponding rising edge of clk_360 such that as Vrise is decreased, the rising edges of clk_360 are delayed and shifted to the right. Similarly, as Vrise is increased, the rising edges of clk_360 are shifted to the left. In this manner, Vrise can be adjusted by CP 124 in response to up/down signals from PFD 122 until the rising edges of clk_in and clk_360 are aligned.

Note that adjusting Vrise does not affect the falling edges of clk_360. Instead, the addition of transistor 316 between inverter 308 and ground slows the falling edge at the output of inverter 308 upon a falling edge of clk_in (which results in a rising edge at the input of inverter 308). Transistor 316, with its control input coupled to receive Vfall, operates in a similar manner to transistor 302, in which as Vfall decreases, the falling edge at the output of transistor 308 slows down, shifting the rising edge at the output of next inverter 310. This therefore shifts the falling edge of clk_360. Note that adjusting Vfall does not affect the rising edges of clk_360, just the falling edges. In this manner, the rising and falling edges of clk_360 (as well as clk_180) can be independently adjusted such that a single delay line (e.g. delay line 110) can be used to control both the rising and falling edges of clk_360.

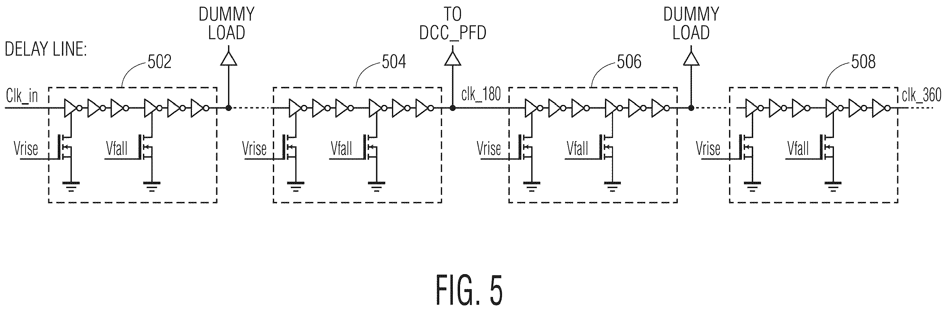

The same description applies to any of the series-connected inverters of delay line 110. That is, any inverter stage of delay line 110 may include rising or falling edge controls, such as through the addition of a transistor controlled by either Vrise or Vfall. In FIG. 3, additional delay units, similar to delay units 390 and 392 can be included, as needed, to generate both clk_360 at an output and an intermediate clock (clk_180) from a tap within the delay line. For example, as seen in the example implementation of FIG. 5, delay line 110 can be implemented with four delay units 502, 504, 506, and 508, all analogous to delay unit 390 of FIG. 3. Each delay unit includes a corresponding set of series-connected inverters. In the illustrated embodiment of FIG. 5, delay line 110 includes an even number of delay units, in which two delay units (e.g. 502 and 504), each having a same even number (e.g. 6) of series-connected inverters are used to generate the 180 degrees shifted clock (clk_180 at the tap within the delay line between units 504 and 506), and two additional delay units (e.g. 506 and 508), each having the same even number (e.g. 6) of series-connected inverters are used to generate clk_360. In one embodiment, to ensure that each delay unit has equal loading, dummy loads can be added between delay units 502 and 504 as well as between delay units 506 and 508. Also, to maintain symmetry between rising and falling edge controls and to make them independent of each other, an inverter pair in series (e.g. inverters 304 and 306) is added after each control stage (e.g. inverter 302/transistor 314). Therefore, any type of circuitry or delay units may be used to selectively shift edges of an input clock to produce an output clock with shifted rising edges and shifted falling edges, in which the shifted rising edges can be shifted by a first delay while the falling edges may be independently shifted by a second delay, different from the first delay.

Referring back to FIG. 3, by being able to shift the rising and falling edges independently (such as by separately controlling Vrise and Vfall), loop 120 can first be enabled and used to lock the rising edges of clk_360 to clk_in, without regard to the falling edges. Then, once the rising edges are locked, loop 130 can be enabled to lock the falling edges of clk_360 to the rising edges of an intermediate clock to result in a desired duty cycle of clk_360. In the illustrated embodiment, the intermediate clock is clk_180 output from delay line 110, resulting in a 50% duty cycle of clk_360. In the illustrated embodiment, assertion of DCC_EN is delayed until after assertion of EN to give DLL loop 120 sufficient time to lock. An example implementation of this delay will be described in reference to FIG. 7. In an alternate embodiment, a specific lock signal or indicator can be provided by CP 124 to indicate when lock has been achieved, and DCC_EN can then be asserted to enable DCC loop 130 in response to that lock signal.

FIG. 7 illustrates more detailed views of a CP 702 and a DCC-CP 730 which may be used as CP 124 and DCC_CP 134, respectively, of FIG. 3, in accordance with an embodiment of the present invention. CP 702 receives UP, UP_b, DN, and DN_b from a corresponding PFD such as PFD 122. CP 702 includes current sources 706 and 708, switches 712, 710, 716, and 714, a differential amplifier 704 and a capacitor C1 718. A first terminal of current source 706 is coupled to Vdd, and a second terminal to a circuit node 722. A first current terminal of each of switches 710 and 712 is coupled to node 722. A second current terminal of switch 710 is coupled to a circuit node 720 which is configured to provide Vrise at an output of CP 702. A first current terminal of switch 714 is coupled to node 720, and a second current terminal of switch 714 is coupled to a circuit node 726 at a first terminal of current source 708. A second terminal of current source 708 is coupled to ground. A second terminal of switch 712 is coupled to a circuit node 724 configured to provide a voltage, Vrise_dummy, at an output of amplifier 704. A first current terminal of switch 716 is coupled to node 724, and a second current terminal of switch 716 is coupled to node 726. A first input (e.g. non-inverting input) of amplifier 704 is coupled to node 720 to receive Vrise, and a second input (e.g. inverting input) of amplifier 704 is coupled to node 724 at the output of amplifier 704 to receive Vrise_dummy.

A control terminal of switch 710 is coupled to receive UP, a control terminal of switch 712 is coupled to receive UP_b, a control terminal of switch 714 is coupled to receive DN, and a control terminal of switch 716 is coupled to receive DN_b. Operation is analogous in function to the operation of CP 124 described above. When UP is asserted to a logic level one by PFD 122 (and thus UP_b is negated to a logic level zero), switch 710 is on and switch 712 is off. And during the pulse on UP, while DN is negated to a logic level zero, switch 714 is off and switch 716 is on. A current path is therefore enabled from current source 706 through switch 710 node 726, which results in charging C1 718, causing Vrise to increase. On the other hand, when DN is asserted to a logic level one by PFD 122 (and thus DN_b is negated to a logic level zero), switch 714 is on and switch 716 is off. And during the pulse on DN, while UP is negated to a logic level zero, switch 710 is off and switch 712 is on. A current path is therefore enabled from node 720 through switch 714 to ground, which results in discharging C1 718, causing Vrise to decrease. Differential amplifier 704 acts as a unity gain buffer which drives Vrise_dummy to be equal to Vrise. This ensures that current sources 706 and 708 have alternate paths for the currents when the UP or DN (or both) signals are low, so that the sources are well biased.

CP 730 includes current sources 734 and 736, switches 740, 738, 744, and 742, a differential amplifier 732, a capacitor C2 746, and circuit nodes 758, 756, 750, and 760. These elements are analogous to current sources 706 and 708, switches 712, 710, 716, and 714, differential amplifier 704, capacitor C1 718, and circuit nodes 722, 624, 520, and 726, respectively, of CP 702. Therefore, they are coupled and operate in the same fashion as described with respect to CP 702, except that the control terminals of the switches receive up/down signals from PFD 132 rather than PFD 122. Therefore, a control terminal of switch 738 is coupled to receive DCC_UP, a control terminal of switch 740 is coupled to receive DCC_UP_b, a control terminal of switch 742 is coupled to receive DCC_DN, and a control terminal of switch 744 is coupled to receive DCC_DN_b. Operation is analogous in function to the operation of CP 134 described above. That is, assertion of DCC_UP results in the charging of C2 746, thus increasing Vfall, and assertion of DCC_DN results in the discharging of C2 746, thus decreasing Vfall.

CP 130 also includes a timed enable circuit 756 (including a switch 748, an inverter 752, and a counter 754) to control enabling of CP 730 (and therefore of loop 130). Initially, when loop 120 is first enabled (and thus EN is asserted), PFD 122 and CP 702 operate to achieve a lock of the rising edges of clk_in and clk_360. During this time, though, DCC_EN remains negated at a logic level zero. Therefore, DCC_EN_b is a logic level one which turns on switch 748. Therefore, while loop 120 is enabled but prior to enabling loop 130, Vfall is shorted to Vrise (via switch 748). (Note that while not illustrated in the embodiment of FIG. 7, prior to asserting EN to enable loop 120, Vrise is provided as Vrise0 until EN is asserted, as was described above in reference to switch 332 of CP 124.)

Counter 754 receives a ref_clk (which may be clk_in) and EN. When EN is asserted, counter 754 begins counting edges (e.g. rising edges) of the ref_clk. When it reaches a predetermined count value, DCC_EN is asserted to a logic level one at the output of counter 754. When DCC_EN is asserted, DCC_EN_b is provided at the output of inverter 752 as a logic level zero which turns off switch 748. This disconnects Vrise from Vfall and thus allows CP 730 to independently control Vfall. The predetermined count value used by counter 754 determines the length of the delay between enabling loop 120 and enabling loop 130, and can be set to different values based on the desired delay, but should at least be set to a long enough delay to give DLL loop 120 time to lock. Counter 754 can be implemented in many different ways. For example, counter 754 can be set up to count rising edges, falling edges, or pulses of the ref_clk, and can be set to count up to a count value or count down from a count value, etc.. Also, a different clock may be used as the ref_clk. Note that alternate embodiments may also use different timing circuits in place of timed enable circuit 756 to ensure the appropriate timing between asserting EN and DCC_EN.

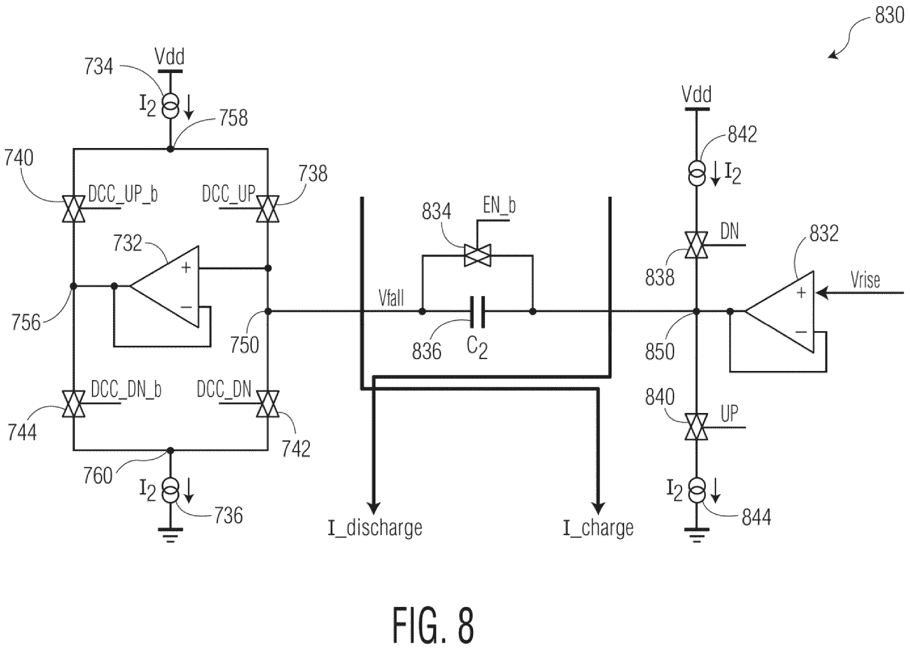

FIG. 8 illustrates CP 830 which is an alternate embodiment of CP 730, in which like numerals indicate like references, in accordance with an embodiment of the present invention. CP 830 controls timing between enabling loop 120 and loop 130 without the explicit use a timing circuit asserting the DCC_EN signal. In CP 830, a first terminal of C2 836 (similar to capacitor C2 746 of CP 730) is coupled to node 750 (the same as C2 746), but a second terminal of C2 is coupled to a circuit node 850 rather than ground. CP 830 also includes a switch 834 having a first current terminal coupled to node 750, a second current terminal coupled to node 850, and a control terminal coupled to receive EN_b. CP 830 includes a differential amplifier 832 having a first input (e.g. non-inverting input) coupled to receive Vrise (such as from node 720 of CP 702), an output coupled to node 850, and a second input (e.g. inverting input) coupled to the output of amplifier 832 at node 850. CP 830 also includes current sources 842 and 844, and switches 838 and 840. A first terminal of current source 842 is coupled to Vdd, a second terminal of current source 842 is coupled to a first current terminal of switch 838. A second terminal of switch 838 is coupled to node 850, and a control terminal of switch 838 is coupled to receive DN. A first current terminal of switch 840 is coupled to node 850, a second terminal of switch 840 is coupled to a first terminal of current source 844, and a second terminal of current source 844 is coupled to ground. A control terminal of switch 840 is coupled to receive UP.

In operation, CP 830 operates differently than CP 730 to couple Vfall to Vrise. Prior to enabling loop 120, with EN still negated at a logic level zero and EN_b at a logic level high, switch 834 is on, which shorts Vrise to Vfall (ensuring C2 836 is fully discharged). Once EN is asserted, though, switch 834 is turned off and Vfall is coupled to Vrise via C2 836 such that the small volage difference between Vrise and Vfall appears on C2 836. This allows for proper initialization without the need of a counter (as was needed for CP 730) or an explicit external lock signal because Vfall follows Vrise with the voltage difference over C2 836. Amplifier 832 acts as a buffer between Vfall and Vrise such that Vfall or C2 836 does not affect Vrise. With C2 836 coupled as shown in CP 830, Vrise is capable of being fixed quickly but Vfall is changed more slowly. Since Vfall follows Vrise, the need for DCC_EN is removed. In this embodiment, EN is used to control enabling of both DLL PFD122 and DCC PFD132. Current sources 842 and 844, and switches 838 and 840 operate to consume sufficient current within CP 830, as shown with the charge and discharge paths, labeled "I-charge" and "I-discharge," respectively, in FIG. 8.

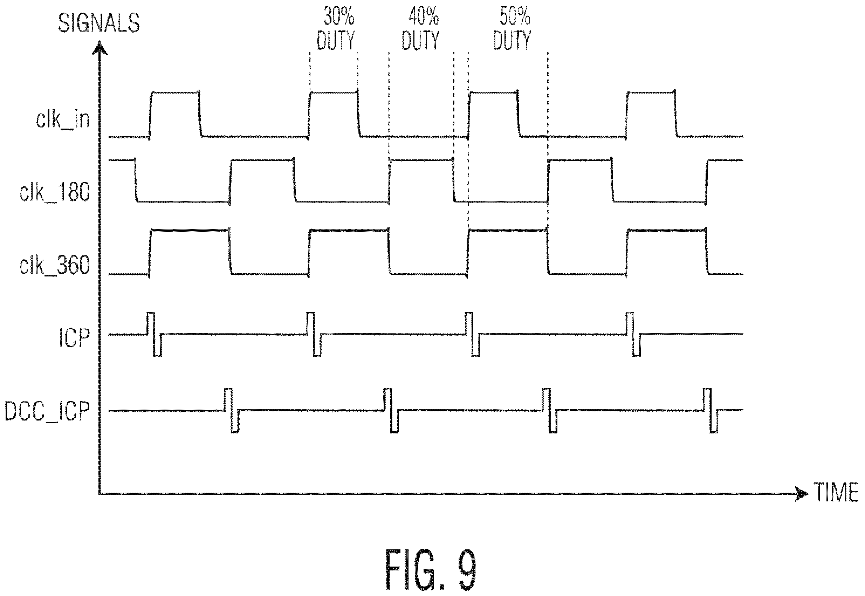

FIG. 9 illustrates example waveforms of DLL circuit 100, in which clk_in has a 30% duty cycle and clk_360 is output phase locked with clk_in but with a duty cycle extended to 50%. The waveforms of FIG. 9 correspond to the steady state waveforms. Initially, though, upon first enabling DLL loop 120, the rising edges of clk_360 are locked to the rising edges of clk_in. After the rising edges are locked, DCC loop 130 is enabled so as to align the falling edges of clk_360 with the rising edges of clk_180, in which the duty cycle of clk_360 gets extended over time, with each subsequent clock cycle, as Vfall is adjusted each cycle by PFD 132 and DCC-CP 134, until lock is achieved. Once lock is achieved by DCC loop 130, steady state is achieved, as illustrated in FIG. 9, in which clk_360 now has a duty cycle of 50%. Note that the resulting duty cycle of clk_180 at steady state is at 40%, which is less than 50%.

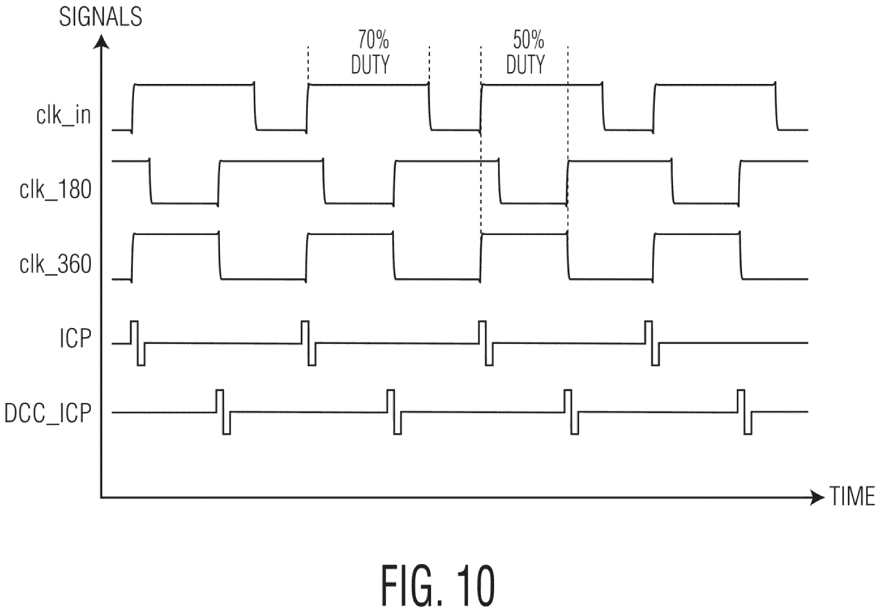

FIG. 10 illustrates the same signals as in FIG. 9, but clk_in has a 70% duty cycle in which clk_360 is output phase locked with clk_in but with a duty cycle reduced to 50%. The waveforms of FIG. 10 also correspond to the steady state waveforms. Initially, though, upon first enabling DLL loop 120, the rising edges of clk_360 are locked to the rising edges of clk_in. After the rising edges are locked, DCC loop 130 is enabled so as to align the falling edges of clk_360 with the rising edges of clk_180, in which the duty cycle of clk_360 gets reduced over time, with each subsequent clock cycle, as Vfall is adjusted each cycle by PFD 132 and DCC-CP 134, until lock is achieved. Once lock is achieved by DLL loop 130, steady state is achieved, as illustrated in FIG. 10, in which clk_360 now has a duty cycle of 50%.

In the illustrated embodiments of FIGs. 3, 9, and 10, DCC loop 130 locks the falling edges to intermediate clk_180 provided by delay line 110 (in which delay line 110 also provides clk_360). By locking the falling edges of clk_360 to rising edges of clk_180, the duty cycle of clk_360 is set to exactly 50% (because the rising edges of clk_180, as illustrated in FIG. 2 above, occur exactly between rising edges of clk_360). However, in an alternate embodiment, a different intermediate clock from delay line 110 (other than clk_180) may instead be provided as the ref_clk of PFD 132. In this case, the duty cycle of clk_360 would be set based on how much the intermediate clock is phase shifted from clk_in. For example, if shifted by 30%, then the duty cycle of cllk_360 would be corrected to 30%.

Also, note that the above embodiments have been described with respect to DLL loop 120 locking rising edges between the input and output clocks, and DCC loop 130 locking falling edges of the output clock with rising edges of the intermediate clocks. However, in alternate embodiments, each of DLL loop 120 and DCC loop 130 can instead achieve lock between different types of edges to achieve an output clock that is phase locked to the input clock and having a corrected duty cycle. For example, DLL loop 120 may instead lock falling edges between input and output clocks and DCC loop 130 may instead lock rising edges of the output clock with falling edges of an intermediate clock to achieve a corrected duty cycle. Therefore, in alternate embodiments, either the rising or falling edges may be used of the input clock, output clock, and intermediate clock, as needed, to achieve phase locking and correction of the duty cycle.

FIG. 4 illustrates DLL circuit 100 of FIG. 2 (in which like numerals indicates like references), with a delay line replica 402 which additional delay units, as needed, similar to delay units 390 or 392 or any of the delay units of FIG. 5, in order to provide multiple phases of the duty cycle corrected clock. For example, a delay unit may be used, like delay unit 390, which receives the duty cycle corrected clock output from DLL delay line 110 (clk_360) as an input and provides the same duty cycle corrected clock but phase shifted by a desired phase shift. In this case, since the duty cycle of the input clock to delay line replica 402 is already at the desired 50% duty cycle, Vrise can be provided to the control terminals of the additional NMOS transistors in the pull-down paths of the control stages, as illustrated in FIG.4, to phase shift the rising edges as desired. If replica delay unit 402 is implemented as illustrated in FIG. 5, different taps of the delay line may be used to provide phase shifted versions of clk_360 as desired or needed in an application.

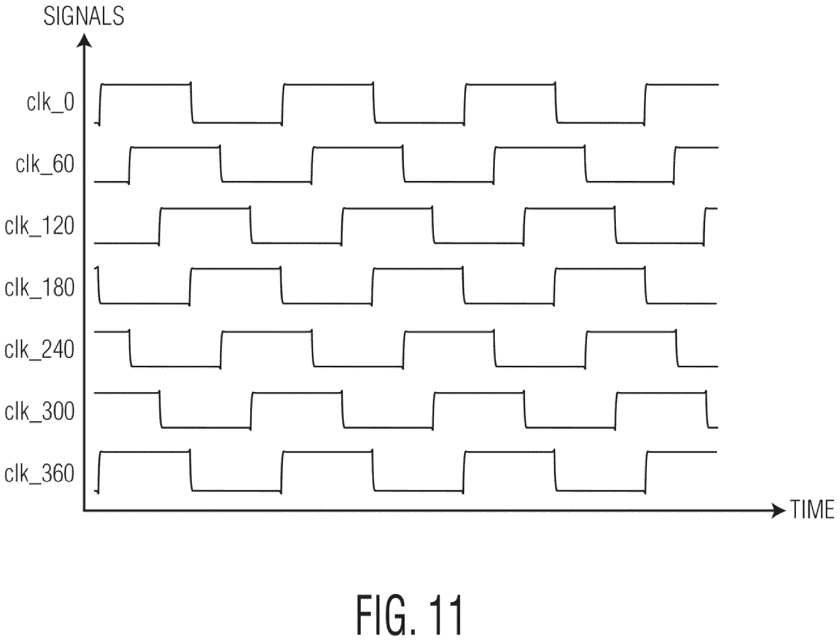

For example, FIG. 11 illustrates various steady state waveforms which can be generated by replica delay line 402. In the illustrated embodiment, the first clock signal, clk_0, corresponds to an output clock provided by replica delay line 402 which does not provide any additional phase shifting (clk_0 is the same as the input clock, clk_360). Each subsequent clock signal is provided by a corresponding tap of replica delay line 402 to provide the desired phase shift. For example, a first tap may be used to provide cllk_60, which is equivalent to clk_360 shifted by 60 degrees, while a second tap may be used to provide clk_120, which is equivalent to clk_360 shifted by 120 degrees, etc. Replica delay line 402 may be designed as needed to provide the various desired phase shifted duty cycle corrected output clocks.

Therefore, by now it can be understood how a DLL circuit can provide a duty cycle corrected clock using a shared delay line by using a DLL loop to phase lock an output clock with an input clock, and after achieving lock, enabling a DCC loop to independently control a falling edge of the output clock so as to lock the falling edges of the output clock with rising edges of an intermediate clock. In one embodiment, the intermediate clock corresponds to a shifted version of the input clock which is shifted by 180 degrees. In one embodiment, the shared delay line provides the output clock at a first tap of the shared delay line and provides the intermediate clock from a second tap of the shared delay line, in which the second tap is located between the input and the first tap of the shared delay line. The falling edges of the output clock are locked to rising edges of an inverse of the intermediate clock, which results in correcting the duty cycle to a 50% duty cycle regardless of the duty cycle of the input clock. A single shared delay line can be used to provide the intermediate clock as well as the output clock, in which the single share delay line can receive a first control voltage to shift rising edges of the input clock and a second control voltage to independently shift the falling edges of the clock. In one embodiment, the DLL loop includes a corresponding PFD and CP to provide the first control voltage to the shared delay line to control the rising edges, and the DCC loop includes its own corresponding PFD and CP to provide the second control voltage to the shared delay line to control the falling edges.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by "_b" or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality. Also for example, in one embodiment, the illustrated elements of system 100 are circuitry located on a single integrated circuit or within a same device.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, different implementations of a PFD, CP, or delay unit may be used. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

A delay locked loop (DLL) circuit includes a delay line which receives an input clock, and provides an output clock which is phase shifted 360 degrees and an intermediate clock which is phase shifted less than 360 degrees from the input clock. A DLL loop receives the input clock as a DLL reference clock and the output clock as a DLL feedback clock, and outputs a first control voltage to adjust first edges of the input clock. A duty cycle correction (DCC) loop receives the intermediate clock as a DCC reference clock and an inverse of the output clock as a DCC feedback clock, and outputs a second control voltage to adjust second edges of the input clock, independent of the first edges of the input clock. The DCC loop is enabled after the DLL loop achieves lock between the first edges of the output clock and the input clock.

In one embodiment, a delay locked loop (DLL) circuit includes a delay line configured to receive an input clock, provide an output clock which is phase shifted 360 degrees from the input clock, and provide an intermediate clock which is phase shifted less than 360 degrees from the input clock; a DLL loop coupled to receive the input clock as a DLL reference clock, the output clock as a DLL feedback clock, and configured to output a first control voltage to the delay line to adjust first edges of the input clock; and a duty cycle correction (DCC) loop coupled to receive the intermediate clock as a DCC reference clock and an inverse of the output clock as a DCC feedback clock, and configured to output a second control voltage to the delay line to adjust second edges of the input clock, independent of the first edges of the input clock, wherein the DCC loop is enabled after the DLL loop achieves lock between the first edges of the output clock and the input clock, wherein the first edges are one of all rising edges or all falling edges and the second edges are another one of all rising edges or all falling edges. In one aspect, the DCC loop includes a DCC phase frequency detector (PFD) coupled to receive the DCC reference clock and the DCC feedback clock, and configured to generate a set of DCC control signals in response to a comparison between the DCC reference clock and the DCC feedback clock; and a DCC charge pump (CP) coupled to receive the set of DCC control signals to adjust an output control voltage of the DCC CP, wherein the output control voltage of the DLL CP is provided as the second control voltage to the delay line. In a further aspect, the DLL loop includes a DLL PFD coupled to receive the DLL reference clock and the DLL feedback clock, and configured to generate a set of DLL control signals in response to a comparison between the DLL reference clock and the DLL feedback clock; and a DLL CP coupled to receive the set of DLL control signals to adjust an output control voltage of the DLL CP, wherein the output control voltage of the DLL CP is provided as the first control voltage to the delay line. In another aspect of the above embodiment, the DCC loop is configured to, once enabled, adjust the second edges of the output clock to achieve lock between the second edges of the output clock and the first edges of the intermediate clock, resulting in a corrected duty cycle. In a further aspect, the resulting corrected duty cycle is based on the phase shift between the intermediate clock and the input clock. In yet a further aspect, a duty cycle of the input clock is not the desired duty cycle. In another aspect, after the DLL loop is enabled but before the DCC loop is enabled, the second control voltage is set to the first control voltage, and after the DCC loop is enabled, the DCC loop controls the second control voltage. In another aspect of the above embodiment, the first edges are all rising edges and the second edges are all falling edges, the intermediate clock is phase shifted 180 degrees from the input clock and is provided by a tap within the delay line, and wherein the DCC loop is configured to adjust the falling edges of the output clock such that, upon achieving lock between falling edges of the output clock and rising edges of the intermediate clock, the output clock has as a corrected duty cycle of 50%. In a further aspect, the input clock has a duty cycle that is either greater than or less than 50%, and upon the DCC loop achieving lock, rising edges of the output clock are aligned with rising edges of the input clock and the output clock has a 50% duty cycle. In another aspect, the delay line includes a plurality of series-connected inverters, wherein a first inverter the plurality of series-connected inverters is configured to receive the input clock, a last inverter of the plurality of series-connected inverters is configured to provide the output clock, and an inverter between the first and last inverter of the plurality of series-connected inverters is configured to provide the intermediate clock. In yet another aspect, the DLL circuit further includes a set of additional delay lines, each configured to receive the output clock from the delay line, and each configured to generate a corresponding delayed output clock that is phase shifted by a corresponding amount from the output clock and matches a duty cycle of the output clock. In another aspect, the DCC loop is enabled a predetermined amount of time after the DLL loop is enabled.

In another embodiment, a delay locked loop (DLL) circuit includes a delay line configured to receive an input clock, provide an output clock which is phase shifted 360 degrees from the input clock, and provide an intermediate clock from a tap within the delay line, wherein the intermediate clock is phase shifted 180 degrees from the input clock; a DLL loop coupled to receive the input clock as a DLL reference clock, the output clock as a DLL feedback clock, and configured to output a first control voltage to the delay line to adjust rising edges of the input clock; and a duty cycle correction (DCC) loop coupled to receive the intermediate clock as a DCC reference clock and an inverse of the output clock as a DCC feedback clock, and configured to output a second control voltage to the delay line to adjust falling edges of the input clock, independent of the rising edges of the input clock, to adjust a duty cycle of the input clock, wherein the DCC loop is enabled after the DLL loop achieves lock between the rising edges of the output clock and the input clock, and, upon the DCC loop achieving lock between the falling edges of the output clock and rising edges of the intermediate clock, the output clock is phase locked with the input clock and has a 50% duty cycle. In one aspect, the DCC loop includes a DCC phase frequency detector (PFD) coupled to receive the DCC reference clock and the DCC feedback clock, and configured to generate a set of DCC control signals in response to a comparison between the DCC reference clock and the DCC feedback clock; and a DCC charge pump (CP) coupled to receive the set of DCC control signals to adjust an output control voltage at an output node of the DCC CP, wherein the output control voltage at the output node of the DCC CP is provided as the second control voltage to the delay line; and the DLL loop includes a DLL PFD coupled to receive the DLL reference clock and the DLL feedback clock, and configured to generate a set of DLL control signals in response to a comparison between the DLL reference clock and the DLL feedback clock; and a DLL CP coupled to receive the set of DLL control signals to adjust an output control voltage at an output node of the DLL CP, wherein the output control voltage at the output node of the DLL CP is provided as the first control voltage to the delay line. In a further aspect, the DLL circuit further includes an amplifier having an output, a first input coupled to the output of the amplifier, and a second input coupled to the output node of the DLL CP, wherein a capacitor of the DCC CP has a first terminal coupled to the output node of the DCC CP and a second terminal coupled to the output of the amplifier, wherein the output node of the DCC CP is shorted to the output of the amplifier prior to enabling the DLL loop and the output node of the DCC CP is coupled to the output of the amplifier via the capacitor of the DCC CP upon enabling the DLL loop. In another aspect, the DCC loop is enabled a predetermined amount of time after the DLL loop is enabled. In another aspect of the another embodiment, the delay line includes a plurality of series-connected inverters, wherein a first inverter the plurality of series-connected inverters is configured to receive the input clock, a last inverter of the plurality of series-connected inverters is configured to provide the output clock, and an inverter between the first and last inverter of the plurality of series-connected inverters is configured to provide the intermediate clock. In another aspect, the DLL circuit further includes a set of additional delay lines, each configured to receive the output clock from the delay line, and each configured to generate a corresponding delayed output clock that is phase shifted a corresponding amount from the output clock and matches a duty cycle of the output clock.

In yet another embodiment, in a delay locked loop (DLL) circuit, a method includes receiving, by a delay line, an input clock; providing an output clock from a first tap of the delay line which is phase shifted 360 degrees from the input clock and an intermediate clock from a second tap of the delay line which is phase shifted 180 degrees from the input clock; enabling a DLL loop to achieve lock between rising edges of the output clock and rising edges of the input clock based on comparisons between the output clock and the input clock; and, a delay time after the DLL loop is enabled, enabling a DCC loop to achieve lock between falling edges of the output clock and rising edges of the intermediate clock based on comparisons between an inverse of the output clock and the intermediate clock, wherein, upon the DCC loop achieving lock, the output clock is phase locked to the input clock and has a corrected 50% duty cycle. In one aspect, the method further includes, upon enabling the DLL loop, starting a counter, wherein the DCC loop is enabled in response to the counter indicating expiration of the delay time.

## Claims

1. A delay locked loop (DLL) circuit comprising:
a delay line configured to receive an input clock, provide an output clock which is phase shifted 360 degrees from the input clock, and provide an intermediate clock which is phase shifted less than 360 degrees from the input clock;
a DLL loop coupled to receive the input clock as a DLL reference clock, the output clock as a DLL feedback clock, and configured to output a first control voltage to the delay line to adjust first edges of the input clock; and
a duty cycle correction (DCC) loop coupled to receive the intermediate clock as a DCC reference clock and an inverse of the output clock as a DCC feedback clock, and configured to output a second control voltage to the delay line to adjust second edges of the input clock, independent of the first edges of the input clock, wherein the DCC loop is enabled after the DLL loop achieves lock between the first edges of the output clock and the input clock, wherein the first edges are one of all rising edges or all falling edges and the second edges are another one of all rising edges or all falling edges.

2. The DLL circuit of claim 1, wherein the DCC loop comprises:
a DCC phase frequency detector (PFD) coupled to receive the DCC reference clock and the DCC feedback clock, and configured to generate a set of DCC control signals in response to a comparison between the DCC reference clock and the DCC feedback clock; and
a DCC charge pump (CP) coupled to receive the set of DCC control signals to adjust an output control voltage of the DCC CP, wherein the output control voltage of the DLL CP is provided as the second control voltage to the delay line.

3. The DLL circuit of claim 1 or 2, wherein the DLL loop comprises:
a DLL PFD coupled to receive the DLL reference clock and the DLL feedback clock, and configured to generate a set of DLL control signals in response to a comparison between the DLL reference clock and the DLL feedback clock; and
a DLL CP coupled to receive the set of DLL control signals to adjust an output
control voltage of the DLL CP, wherein the output control voltage of the DLL CP is provided as the first control voltage to the delay line.

4. The DLL circuit of any preceding claim, wherein the DCC loop is configured to, once enabled, adjust the second edges of the output clock to achieve lock between the second edges of the output clock and the first edges of the intermediate clock, resulting in a corrected duty cycle.

5. The DLL circuit of claim 4, wherein the resulting corrected duty cycle is based on the phase shift between the intermediate clock and the input clock.

6. The DLL circuit of claim 5, wherein a duty cycle of the input clock is not the desired duty cycle.

7. The DLL circuit of claim 4 or 5, wherein, after the DLL loop is enabled but before the DCC loop is enabled, the second control voltage is set to the first control voltage, and after the DCC loop is enabled, the DCC loop controls the second control voltage.

8. The DLL circuit of any preceding claim, wherein the first edges are all rising edges and the second edges are all falling edges, the intermediate clock is phase shifted 180 degrees from the input clock and is provided by a tap within the delay line, and wherein the DCC loop is configured to adjust the falling edges of the output clock such that, upon achieving lock between falling edges of the output clock and rising edges of the intermediate clock, the output clock has as a corrected duty cycle of 50%.

9. The DLL circuit of claim 8, wherein the input clock has a duty cycle that is either greater than or less than 50%, and upon the DCC loop achieving lock, rising edges of the output clock are aligned with rising edges of the input clock and the output clock has a 50% duty cycle.

10. The DLL circuit of any preceding claim, wherein the delay line comprises a plurality of series-connected inverters, wherein a first inverter the plurality of series-connected inverters is configured to receive the input clock, a last inverter of the plurality of series-connected inverters is configured to provide the output clock, and an inverter between the first and last inverter of the plurality of series-connected inverters is configured to provide the intermediate clock.

11. The DLL circuit of any preceding claim, further comprising:
a set of additional delay lines, each configured to receive the output clock from the delay line, and each configured to generate a corresponding delayed output clock that is phase shifted by a corresponding amount from the output clock and matches a duty cycle of the output clock.

12. The DLL circuit of any preceding claim, wherein the DCC loop is enabled a predetermined amount of time after the DLL loop is enabled.

13. A delay locked loop (DLL) circuit comprising:
a delay line configured to receive an input clock, provide an output clock which is phase shifted 360 degrees from the input clock, and provide an intermediate clock from a tap within the delay line, wherein the intermediate clock is phase shifted 180 degrees from the input clock;
a DLL loop coupled to receive the input clock as a DLL reference clock, the output clock as a DLL feedback clock, and configured to output a first control voltage to the delay line to adjust rising edges of the input clock; and
a duty cycle correction (DCC) loop coupled to receive the intermediate clock as a DCC reference clock and an inverse of the output clock as a DCC feedback clock, and configured to output a second control voltage to the delay line to adjust falling edges of the input clock, independent of the rising edges of the input clock, to adjust a duty cycle of the input clock, wherein:
the DCC loop is enabled after the DLL loop achieves lock between the rising edges of the output clock and the input clock, and
upon the DCC loop achieving lock between the falling edges of the output clock and rising edges of the intermediate clock, the output clock is phase locked with the input clock and has a 50% duty cycle.

14. The DLL circuit of claim 13, wherein:
the DCC loop comprises:
a DCC phase frequency detector (PFD) coupled to receive the DCC reference clock and the DCC feedback clock, and configured to generate a set of DCC control signals in response to a comparison between the DCC reference clock and the DCC feedback clock; and
a DCC charge pump (CP) coupled to receive the set of DCC control signals to adjust an output control voltage at an output node of the DCC CP, wherein the output control voltage at the output node of the DCC CP is provided as the second control voltage to the delay line; and
the DLL loop comprises:
a DLL PFD coupled to receive the DLL reference clock and the DLL feedback clock, and configured to generate a set of DLL control signals in response to a comparison between the DLL reference clock and the DLL feedback clock; and
a DLL CP coupled to receive the set of DLL control signals to adjust an output control voltage at an output node of the DLL CP, wherein the output control voltage at the output node of the DLL CP is provided as the first control voltage to the delay line.

15. The DLL circuit of claim 14, further comprising:
an amplifier having an output, a first input coupled to the output of the amplifier, and a second input coupled to the output node of the DLL CP, wherein a capacitor of the DCC CP has a first terminal coupled to the output node of the DCC CP and a second terminal coupled to the output of the amplifier, wherein the output node of the DCC CP is shorted to the output of the amplifier prior to enabling the DLL loop and the output node of the DCC CP is coupled to the output of the amplifier via the capacitor of the DCC CP upon enabling the DLL loop.
